(19) **Europäisches Patentamt / European Patent Office / Office européen des brevets**

(11) **EP 3 667 821 B1**

(12) **EUROPEAN PATENT SPECIFICATION**

(45) Date of publication and mention
of the grant of the patent:
**29.11.2023 Bulletin 2023/48**

(21) Application number: **18863538.7**

(22) Date of filing: **18.05.2018**

(51) International Patent Classification (IPC):
*H01Q 1/52* (2006.01)    *H01Q 3/26* (2006.01)
*H01Q 21/00* (2006.01)    *H01Q 9/04* (2006.01)
*H01Q 21/06* (2006.01)

(52) Cooperative Patent Classification (CPC):
**H01Q 3/26; H01Q 1/523; H01Q 9/0464;
H01Q 21/0075; H01Q 21/0093; H01Q 21/065**

(86) International application number:
**PCT/JP2018/019225**

(87) International publication number:
**WO 2019/064683 (04.04.2019 Gazette 2019/14)**

(54) **ARRAY ANTENNA DEVICE**

GRUPPENANTENNENVORRICHTUNG

DISPOSITIF D'ANTENNE RÉSEAU

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.09.2017 PCT/JP2017/035232**

(43) Date of publication of application:
**17.06.2020 Bulletin 2020/25**

(73) Proprietor: **Mitsubishi Electric Corporation**
**Chiyoda-ku**
**Tokyo 100-8310 (JP)**

(72) Inventors:
- **YOKOKAWA, Kei**
  **Tokyo 100-8310 (JP)**
- **NAKAMOTO, Narihiro**
  **Tokyo 100-8310 (JP)**
- **FUKASAWA, Toru**
  **Tokyo 100-8310 (JP)**
- **TAKAHASHI, Tomohiro**
  **Tokyo 100-8310 (JP)**
- **OTSUKA, Masataka**
  **Tokyo 100-8310 (JP)**

(74) Representative: **Pfenning, Meinig & Partner mbB**
**Patent- und Rechtsanwälte**
**Theresienhöhe 11a**
**80339 München (DE)**

(56) References cited:
WO-A1-2013/121732    WO-A2-2012/167283
JP-A- 2007 324 712    JP-A- 2011 097 526
US-A1- 2012 154 238    US-A1- 2014 151 860
US-A1- 2016 049 723    US-A1- 2016 087 333
US-A1- 2016 172 317

- KHANDELWAL N ET AL: "Active Antenna Module for Low-Cost Electronically Scanned Phased Arrays", IEEE TRANSACTIONS ON MICROWAVE THEORY AND TECHNIQUES, PLENUM, USA, vol. 56, no. 10, 1 October 2008 (2008-10-01), pages 2286-2292, XP011235160, ISSN: 0018-9480, DOI: 10.1109/TMTT.2008.2003122
- PINEL, S. et al.: "3D integrated LTCC module using mu/BGA technology for compact C-band RF front-end module", 2002 IEEE MTT- S International Microwave Symposium Digest, 2002, pages 1553-1556, XP001113901,
- HONG, W. B. et al.: "24-element antenna-in-package for stationary 60-GHz communication scenarios", IEEE Antennas and Wireless Propagation Letters, vol. 10, 2011, pages 738-741, XP011403014, DOI: 10.1109/LAWP.2011.2162640
- CARRILLO-RAMIREZ, R. et al.: "A Highly integrated millimeter-wave active antenna array using BCB and silicon substrate", IEEE Transactions on Microwave Theory and Techniques, vol. 52, no. 6, 2004, pages 1648-1653, XP001195918, DOI: 10.1109/TMTT.2004.828469

**Description**

TECHNICAL FIELD

The present invention relates to an array antenna device including a plurality of patch antennas.

BACKGROUND ART

It is desirable that array antenna devices used for wireless communication, for example, have a high gain and a high axial ratio even with a weak radio wave when scanning with a beam is performed in a wide-angle direction in order to enable wireless communication over the wide angle. The wide-angle direction is a direction in which a radio wave is transmitted/received at ends of the beam width.
A decrease in the gain and the a decrease in the axial ratio when scanning with the beam is performed in the wide-angle direction are caused by a difference in the amplitude between a vertically polarized wave and a horizontally polarized wave in the wide-angle direction, in addition to surface waves generated in a dielectric substrate on which patch antennas are formed.
An array antenna device disclosed in the following Patent Literature 1 employs a substrate having a low dielectric constant characteristic such as foam as a dielectric substrate in order to suppress a decrease in the gain and a decrease in the axial ratio when scanning with a beam is performed in a wide-angle direction.
A difference in the amplitude between a vertically polarized wave and a horizontally polarized wave in the wide-angle direction can be changed by adjusting the thickness of the substrate having a low dielectric constant characteristic such as foam.
In this array antenna device, a screw is used to adjust the thickness of the substrate. Patent Literature 2 describes an integrated millimeter wave transceiver which is capable of operating with millimeter waves and capable of issuing and receiving signals from devices arranged at distances greater than one meter. In Patent Literature 3 a wireless communications package structure is described which forms a compact integrated radio/wireless communications systems for millimeter wave applications.

CITATION LIST

PATENT LITERATURE

Patent Literature 1: JP 2009-188895 A
Patent Literature 2: US 2012 154238 A1
Patent Literature 3: US 2016 049723 A1

SUMMARY OF INVENTION

TECHNICAL PROBLEM

Since the array antenna devices are configured as described above, the thickness of the substrate can be adjusted by the screws.
In this example, the amount of adjustment of the thickness of the substrate is proportional to the amount of rotation of the screw, and the amount of rotation of the screw is dependent on the pitch of the screw thread. For this reason, the adjustment accuracy of the thickness of a substrate can be improved as the pitch of a screw thread becomes narrower.
For example in a case where the frequency band of a beam is high such as the Kurz-above (Ka) band or a millimeter wave band, it is necessary to use a screw having a thread pitch in the order of micrometers in order to implement a desired adjustment accuracy.
However, since it is difficult to manufacture a screw having a thread pitch in the order of micrometers, there are cases where the thickness of the substrate cannot be adjusted with high accuracy and the thickness of the substrate cannot be adjusted to a desired thickness. It is a disadvantage in that, as a result, a decrease in the gain and a decrease in the axial ratio cannot be suppressed when scanning with a beam is performed in the wide-angle direction.
The present invention has been devised in order to solve the above disadvantage, and it is an object of the present invention to obtain an array antenna device capable of suppressing a decrease in the gain and a decrease in the axial ratio when scanning with a beam is performed in the wide-angle direction.

SOLUTION TO PROBLEM

An array antenna device according to claim 1.

ADVANTAGEOUS EFFECTS OF INVENTION

According to the present invention, in a case where the first conductor ground plane is formed on the front surface of the first dielectric substrate, a part of the plurality of conductive members penetrates the first dielectric substrate, and the remaining part of the plurality of conductive members functions as spacers for providing an air layer between the first dielectric substrate and the second conductor ground plane, and in a case where the first conductor ground plane is formed on the back surface of the first dielectric substrate, the plurality of conductive members functions as spacers for providing an air layer between the first conductor ground plane and the second conductor ground plane. Therefore, there is an effect of suppressing a decrease in the gain and a decrease in the axial ratio when scanning with a beam is performed in the wide-angle direction.

BRIEF DESCRIPTION OF DRAWINGS

FIG. 1 is a plan view illustrating an array antenna device according to a first embodiment of the present invention.
FIG. 2 is a cross-sectional view illustrating the array antenna device according to the first embodiment of the invention.
FIG. 3 is an explanatory diagram illustrating an effective radius.
FIG. 4 is a cross-sectional view illustrating another array antenna device according to the first embodiment of the invention.
FIG. 5 is a cross-sectional view illustrating an array antenna device according to a second embodiment of the present invention.
FIG. 6 is a cross-sectional view illustrating another array antenna device according to the second embodiment of the invention.
FIG. 7 is a cross-sectional view illustrating an array antenna device according to a third embodiment of the invention.
FIG. 8 is an explanatory diagram illustrating the positional relationship among a first stripline 13, a second stripline 15, and a slot 17 in the array antenna device illustrated in FIG. 7.
FIG. 9 is a cross-sectional view illustrating another array antenna device according to the third embodiment of the invention.
FIG. 10 is an explanatory diagram illustrating the positional relationship among a first stripline 13, a second stripline 15, and a slot 17.
FIG. 11 is an explanatory diagram illustrating the positional relationship among the first stripline 13, the second stripline 15, and the slot 17.
FIG. 12 is a cross-sectional view illustrating an array antenna device according to a fourth embodiment of the invention.
FIG. 13 is a cross-sectional view illustrating another array antenna device according to the fourth embodiment of the invention.
FIG. 14 is a cross-sectional view illustrating an array antenna device according to a fifth embodiment of the invention.
FIG. 15 is a cross-sectional view illustrating an array antenna device according to a sixth embodiment of the invention.
FIG. 16 is a cross-sectional view illustrating another array antenna device according to the sixth embodiment of the invention.
FIG. 17 is a cross-sectional view illustrating an array antenna device according to a seventh embodiment of the invention.
FIG. 18 is a cross-sectional view illustrating another array antenna device according to the seventh embodiment of the invention.
FIG. 19 is a cross-sectional view illustrating an array antenna device according to an eighth embodiment of the invention.
FIG. 20 is a plan view illustrating the positional relationship between a first stripline 13 and a second stripline 15.

DESCRIPTION OF EMBODIMENTS

To describe the present invention further in detail, embodiments for carrying out the present invention will be described below with reference to accompanying drawings.

First Embodiment

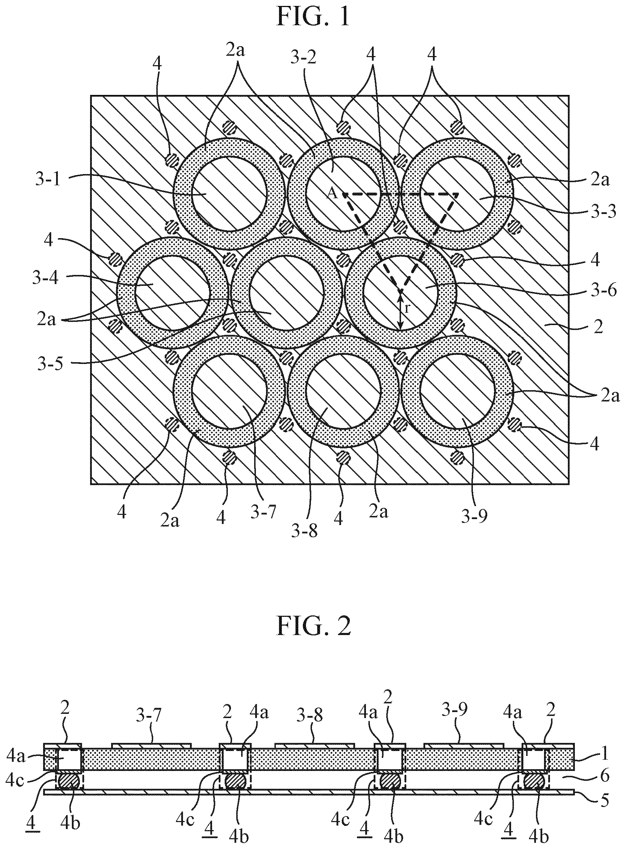

FIG. 1 is a plan view illustrating an array antenna device according to a first embodiment of the present invention.

FIG. 2 is a cross-sectional view illustrating the array antenna device according to the first embodiment of the present invention.

In FIGS. 1 and 2, a first dielectric substrate 1 is provided with a first conductor ground plane 2 formed on a front surface thereof.

The front surface of the first dielectric substrate 1 is the surface on the upper side in FIG. 2 out of the two surfaces of the first dielectric substrate 1, and the back surface of the first dielectric substrate 1 is the surface on the lower side in FIG. 2.

The first conductor ground plane 2 is a ground plane of copper foil formed on the front surface of the first dielectric substrate 1.

Patch antennas 3-1 to 3-9 are circular patch antennas provided on the first conductor ground plane 2.

Hereinafter, when the individual patch antennas 3-1 to 3-9 are not distinguished, they may be referred to as the patch antennas 3.

In FIG. 1 and FIG. 2, the patch antennas 3-1 to 3-9 are formed by scraping the first conductor ground plane 2 in annular shapes. A conductor-cut-out portion 2a indicates an annular cut-out portion in the first conductor ground plane 2.

Although nine patch antennas 3 are illustrated as an example in FIGS. 1 and 2, the number of patch antennas 3 is only required to be plural and not limited to nine.

To simplify the drawing, the patch antennas 3-7 to 3-9 are representatively illustrated in FIG. 2.

The patch antennas 3-1 to 3-9 have a circular shape.

Conductive members 4 each include a first connection conductor 4a and a second connection conductor 4b, and ends of the conductive members 4 are coupled to the first conductor ground plane 2 so as to surround the patch antennas 3-1 to 3-9 individually.

The first connection conductor 4a which is a part of the conductive member 4 is provided so as to penetrate the first dielectric substrate 1, and one end thereof is coupled to the first conductor ground plane 2 at a position surrounding any of the patch antennas 3-1 to 3-9.

The second connection conductor 4b, which is the remaining part of the conductive member 4, is a copper core ball that conducts between the other end of the first connection conductor 4a and a second conductor ground plane 5.

The second connection conductor 4b functions as a spacer for providing an air layer 6 between the first dielectric substrate 1 and the second conductor ground plane 5.

Although the example in which the second connection conductor 4b is a copper core ball is illustrated here, the second connection conductor 4b is not limited to a sphere and may be, for example, a cube or a rectangular parallelepiped.

A land 4c is a portion where the first connection conductor 4a and the second connection conductor 4b are coupled by solder. The second ground plane 5 is a ground plane of copper foil coupled to each of the other ends of second connection conductors 4b in a plurality of conductive members 4.

The air layer 6 is a layer between the first dielectric substrate 1 and the second conductor ground plane 5 formed by the second connection conductors 4b.

Next, the operation will be described.

In the array antenna device according to the first embodiment, the patch antennas 3-1 to 3-9 are formed by removing the first conductor ground plane 2 in the annular shapes like in the conductor-cut-out portions 2a illustrated in FIG. 1.

The plurality of conductive members 4 is provided in the first dielectric substrate 1 in such a manner that ends of the conductive members 4 surround the patch antennas 3-1 to 3-9 individually.

Specifically, the conductive members 4 each include a first connection conductor 4a and a second connection conductor 4b, and the first connection conductors 4a are provided so as to penetrate the first dielectric substrate 1 with the ends thereof coupled to the first conductor ground plane 2 at positions surrounding one patch antenna 3 out of the patch antennas 3-1 to 3-9.

An end of a second connection conductor 4b is coupled to the other end of a first connection conductor 4a, and the other end of the second connection conductor 4b is coupled to the second conductor ground plane 5.

Here, the second connection conductor 4b functions as a spacer for providing the air layer 6 between the first dielectric substrate 1 and the second conductor ground plane 5.

The size of the air layer 6, which is the length of an interval between the first dielectric substrate 1 and the second conductor ground plane 5, corresponds to the diameter of the second connection conductor 4b which is a copper core ball.

By providing the air layer 6 between the first dielectric substrate 1 and the second conductor ground plane 5, a low dielectric constant substrate can be equivalently implemented.

In addition, a difference in the amplitude between a vertically polarized wave and a horizontally polarized wave in the wide-angle direction can be reduced by adjusting the size of the air layer 6.

In order to suppress a decrease in the gain and a decrease in the axial ratio when scanning with a beam is performed in the wide-angle direction, it is only required to adjust the size of the air layer 6 in such a manner that a difference in the amplitude between a vertically polarized wave and a horizontally polarized wave in the wide-angle direction is reduced.

Since the size of the air layer 6 corresponds to the diameter of the second connection conductor 4b, it is only required to use a second connection conductor 4b having a diameter that allows a difference in the amplitude between the vertically polarized wave and the horizontally polarized wave in the wide-angle direction to be reduced.

However, in a case where the frequency band of the beam is high such as the Ka band or a millimeter wave band, the size of the air layer 6 needs to be adjusted in the order of micrometers, and thus it is necessary to use second connection conductors 4b manufactured with accuracy in the order of micrometers.

Since it is easier to manufacture copper core balls with high accuracy as compared to manufacturing screws having a narrow thread pitch, it is easy to manufacture copper core balls with accuracy in the order of micrometers. Thus, it is possible to use second connection conductors 4b having a desired diameter.

The example in which the patch antennas 3-1 to 3-9 are formed is illustrated in the first embodiment. Focusing on three adjacent patch antennas 3 out of the patch antennas 3-1 to 3-9, it is desirable that the three patch antennas 3 are disposed in such a manner that a distance between the centers of each pair of the three patch antennas 3 approximately equals a half the wavelength of a frequency of the beam to be transmitted and received.

For example, focusing on the patch antenna 3-2, 3-3, and 3-6 as three adjacent patch antennas 3, the patch antennas 3-2, 3-3, and 3-6 are disposed in such a manner that lines connecting the centers of the three patch antennas become an equilateral triangle A.

The distance between the center of patch antenna 3-2 and the center of patch antenna 3-3 is approximately half the wavelength of the frequency of the beam, and the distance between the center of patch antenna 3-3 and the center of patch antenna 3-6 is approximately half the wavelength of the frequency of the beam. The distance between the center of patch antenna 3-6 and the center of patch antenna 3-2 is approximately half the wavelength of the frequency of the beam.

The radius r of the patch antennas 3-1 to 3-9 is expressed as the following equation (1), using an effective dielectric constant $\varepsilon_r$ calculated from the first dielectric substrate 1 and the air layer 6.

$$r = \frac{c}{4(f \times \sqrt{\varepsilon_r})} \qquad (1)$$

In equation (1), c represents the speed of light, and f represents the frequency of the beam.

The effective dielectric constant $\varepsilon_r$ is expressed as the following equation (2), where the thickness of the first dielectric substrate 1 is denoted by $t_1$, a dielectric constant of the first dielectric substrate 1 is denoted by $\varepsilon_{r1}$, the thickness of the air layer 6 is denoted by $t_2$, and the dielectric constant of the air layer 6 is denoted by $\varepsilon_{r2}$.

$$\varepsilon_r = \frac{t_1 + t_2}{\frac{t_1}{\varepsilon_{r1}} + \frac{t_2}{\varepsilon_{r2}}} \qquad (2)$$

The conductive members 4 are disposed at positions surrounding the patch antennas 3-1 to 3-9 individually.

As one of the positions where the conductive members 4 are disposed, for example, the center of gravity of the equilateral triangle A, which is a position equidistant from the patch antennas 3-2, 3-3, and 3-6 is conceivable.

The diameter of the conductor-cut-out portions 2a surrounding the patch antennas 3-1 to 3-9 is determined in such a manner that an equivalent patch radius from the center of the patch antennas 3-1 to 3-9 (hereinafter referred to as "effective radius") results in an axial ratio characteristic of approximately 0 dB in a target maximum angle of the beam scanning angle. As the target maximum angle of the beam scanning angle, for example, a beam scanning angle of $\pm$ 60 degrees is conceivable.

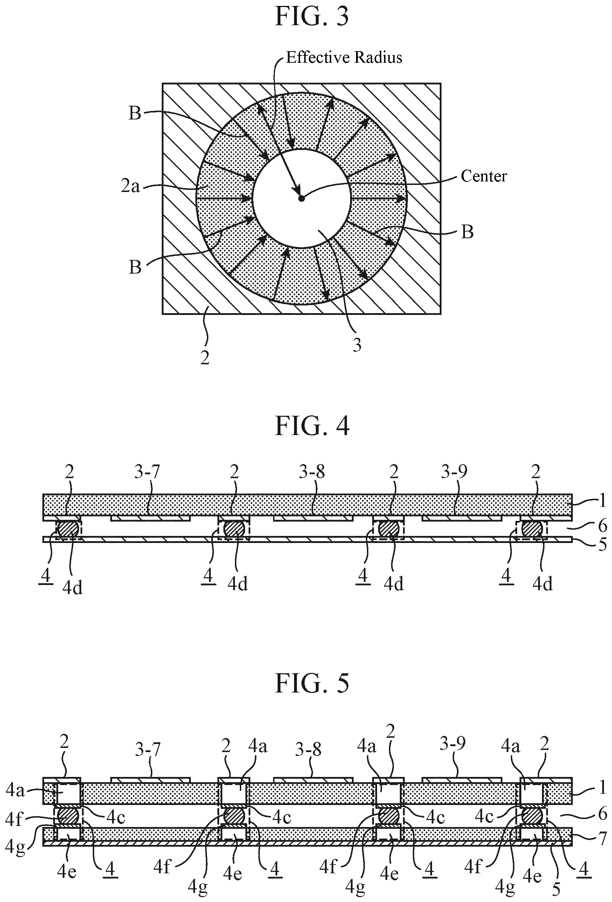

An effective radius is an electrical radius of the patch antennas 3 in consideration of the spread of an electric field B generated in the patch antennas 3 when the power is being fed as illustrated in FIG. 3.

FIG. 3 is an explanatory diagram illustrating an effective radius.

It is known that the axial ratio of the patch antennas 3-1 to 3-9 can be adjusted by the effective radius.

Specifically, in the case where the effective dielectric constant $\varepsilon_r$ is about 1.3 and when the effective radius of the patch antennas 3-1 to 3-9 is about $0.26\lambda$, the axial ratio in the wide-angle direction is obtained as 0 dB, and a resonance characteristic is obtained at the frequency of the beam. Symbol $\lambda$ represents the wavelength at the frequency of a beam used.

Therefore, the first conductor ground plane 2 positioned between about 0.26λ away from the center of the patch antennas 3-1 to 3-9 and the perimeters of the patch antennas 3-1 to 3-9 is each cut out into an annual shape.

Note that there are cases where conductor-cut-out portions 2a of adjacent patch antennas 3 overlap with each other since the radius r of the adjacent patch antennas 3 is large and thus intervals in the arrangement of the adjacent patch antenna 3 become narrow. Since it is only required that adjacent patch antennas 3 do not overlap with each other, conductor-cut-out portions 2a of the adjacent patch antennas 3 may overlap with each other.

As apparent from the above, according to the first embodiment, parts of the plurality of conductive members 4 penetrate the first dielectric substrate 1 while the remaining parts of the plurality of conductive members 4 function as spacers for providing the air layer 6 between the first dielectric substrate 1 and the second conductor ground plane 5, thereby exercising effects of suppressing a decrease in the gain and a decrease in the axial ratio when scanning with a beam is performed in the wide-angle direction.

Since the remaining parts of the conductive members 4 functioning as spacers are the second connection conductor 4b that can be manufactured with accuracy in the order of micrometers, the size of the air layer 6 can be adjusted in the order of micrometers, thereby suppressing a decrease in the gain and a decrease in the axial ratio when scanning with a beam is performed in the wide-angle direction.

The example is illustrated in the first embodiment in which the first conductor ground plane 2 is formed on the front surface of the first dielectric substrate 1; however as illustrated in FIG. 4, the first conductor ground plane 2 may be formed on the back surface of the first dielectric substrate 1.

FIG. 4 is a cross-sectional view illustrating another array antenna device according to the first embodiment of the invention. In FIG. 4, the same symbol as that in FIGS. 1 and 2 represents the same or a corresponding part and thus description thereof is omitted.

A conductive member 4 illustrated in FIG. 2 includes a first connection conductor 4a and a second connection conductor 4b, whereas a conductive member 4 illustrated in FIG. 4 includes only a first connection conductor 4d.

The first connection conductor 4d is a copper core ball one end of which is coupled to a first conductor ground plane 2 at a position surrounding any one of patch antennas 3-1 to 3-9, and the other end of which is coupled to a second conductor ground plane 5.

The first connection conductor 4d functions as a spacer for providing an air layer 6 between the first conductor ground plane 2 and the second conductor ground plane 5.

Since the air layer 6 is provided also in the array antenna device illustrated in FIG. 4, a low dielectric constant substrate can be equivalently implemented like in the array antenna device illustrated in FIGS. 1 and 2.

Therefore, also in the array antenna device illustrated in FIG. 4, it is possible to suppress a decrease in the gain and a decrease in the axial ratio when scanning with a beam is performed in the wide-angle direction like in the array antenna device illustrated in FIGS. 1 and 2.

Second Embodiment

The first embodiment has illustrated the array antenna device including the first dielectric substrate 1, whereas in a second embodiment an array antenna device including a first dielectric substrate 1 and a second dielectric substrate 7 will be described.

FIG. 5 is a cross-sectional view illustrating an array antenna device according to the second embodiment of the present invention.

A plan view of the array antenna device of the second embodiment is illustrated in FIG. 1 as in the first embodiment.

In FIG. 5, the same symbol as that in FIGS. 1 and 2 represents the same or a corresponding part and thus description thereof is omitted.

The second dielectric substrate 7 is disposed between the first dielectric substrate 1 and a second conductor ground plane 5.

Conductive members 4 each include a first connection conductor 4a, a second connection conductor 4e, and a third connection conductor 4f, and ends of the conductive members 4 are coupled to the first conductor ground plane 2 so as to surround each of patch antennas 3-1 to 3-9.

A second connection conductor 4e which is a part of a conductive member 4 is provided so as to penetrate the second dielectric substrate 7, and one end thereof is coupled to the second conductor ground plane 5.

A third connection conductor 4f, which is the remaining part of the conductive member 4, is a copper core ball that conducts between the other end of the first connection conductor 4a and the other end of the second connection conductor 4e.

The third connection conductor 4f functions as a spacer for providing an air layer 6 between the first dielectric substrate 1 and the second dielectric substrate 7.

Although the example in which the third connection conductor 4f is a copper core ball is illustrated here, the third connection conductor 4f is not limited to a sphere and may be, for example, a cube, or a rectangular parallelepiped.

A land 4g is a portion where the second connection conductor 4e and the third connection conductor 4f are coupled by solder.

Although the second dielectric substrate 7 is included in addition to the first dielectric substrate 1 in the second embodiment, since the air layer 6 is provided, a low dielectric constant substrate can be equivalently implemented like in the first embodiment.

Thus, like in the first embodiment described above, it is possible to suppress a decrease in the gain and a decrease in the axial ratio when scanning with a beam is performed in the wide-angle direction.

In the second embodiment, however, since the second dielectric substrate 7 is included in addition to the first dielectric substrate 1, the effective dielectric constant $\varepsilon_r$ is calculated from the first dielectric substrate 1, the second dielectric substrate 7, and the air layer 6.

The effective dielectric constant $\varepsilon_r$ is expressed as the following equation (3), where the thickness of the first dielectric substrate 1 is denoted by $t_1$, the dielectric constant of the first dielectric substrate 1 is denoted by $\varepsilon_{r1}$, the thickness of the air layer 6 is denoted by $t_2$, the dielectric constant of the air layer 6 is denoted by $\varepsilon_{r2}$, the thickness of the second dielectric substrate 7 is denoted by $t_3$, the dielectric constant of the second dielectric substrate 7 is denoted by $\varepsilon_{r3}$.

$$\varepsilon_r = \frac{t_1 + t_2 + t_3}{\frac{t_1}{\varepsilon_{r1}} + \frac{t_2}{\varepsilon_{r2}} + \frac{t_3}{\varepsilon_{r3}}} \qquad (3)$$

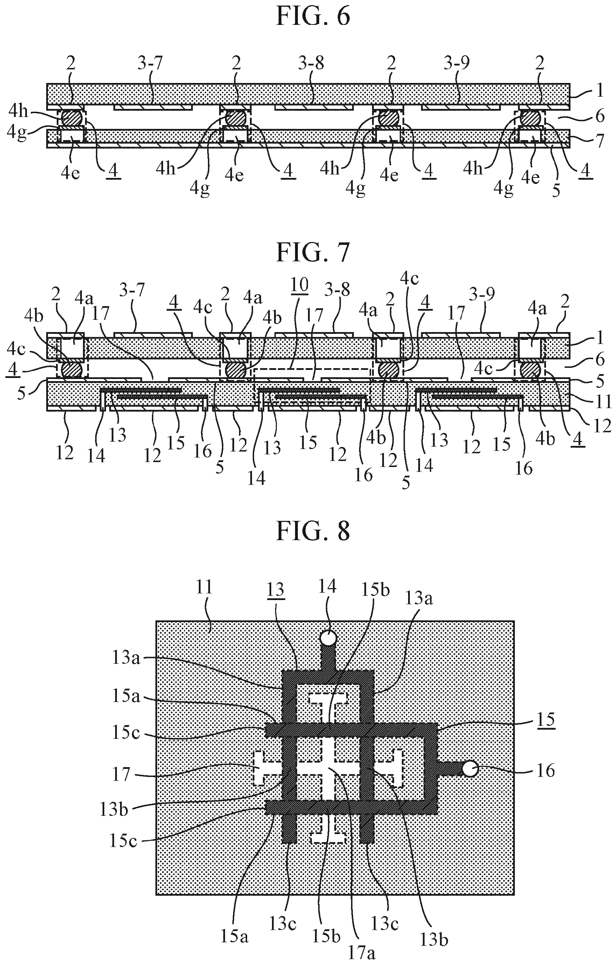

The example is illustrated in the second embodiment in which the first conductor ground plane 2 is formed on the front surface of the first dielectric substrate 1; however as illustrated in FIG. 6, the first conductor ground plane 2 may be formed on the back surface of the first dielectric substrate 1.

FIG. 6 is a cross-sectional view illustrating another array antenna device according to the second embodiment of the invention. In FIG. 6, the same symbol as that in FIGS. 1 and 5 represents the same or a corresponding part and thus description thereof is omitted.

The conductive members 4 illustrated in FIG. 5 each include a first connection conductors 4a, a second connection conductors 4e, and a third connection conductor 4f, whereas conductive members 4 illustrated in FIG. 6 each include only a first connection conductor 4h and a second connection conductor 4e.

The first connection conductor 4h is a copper core ball one end of which is coupled to a first conductor ground plane 2 at a position surrounding any one of patch antennas 3-1 to 3-9.

The first connection conductor 4h functions as a spacer for providing an air layer 6 between the first conductor ground plane 2 and a second dielectric substrate 7.

Since the air layer 6 is provided also in the array antenna device illustrated in FIG. 6, a low dielectric constant substrate can be equivalently implemented like in the array antenna device illustrated in FIG. 5.

Therefore, also in the array antenna device illustrated in FIG. 6, it is possible to suppress a decrease in the gain and a decrease in the axial ratio when scanning with a beam is performed in the wide-angle direction like in the array antenna device illustrated in FIG. 5.

Third Embodiment

In the third embodiment, an array antenna device including first striplines 13, second striplines 15, and slots 17 as feed line portions 10 will be described.

FIG. 7 is a cross-sectional view illustrating an array antenna device according to the third embodiment of the present invention.

A plan view of the array antenna device of the third embodiment is illustrated in FIG. 1 as in the first embodiment.

In FIG. 7, the same symbol as that in FIGS. 1 and 2 represents the same or a corresponding part and thus description thereof is omitted.

A second dielectric substrate 11 is disposed on, out of the two planes of a second conductor ground plane 5, a plane opposite to the plane to which conductive members 4 are coupled.

A third conductor ground plane 12 is a ground plane of copper foil disposed on, out of the two planes of the second dielectric substrate 11, a plane opposite to the plane on which the second conductor ground plane 5 is disposed.

A first stripline 13 is provided at a position facing one patch antenna 3 out of the patch antennas 3-1 to 3-9 inside the second dielectric substrate 11.

A second stripline 15 is provided at a position facing one patch antenna 3 out of the patch antennas 3-1 to 3-9 inside the second dielectric substrate 11.

A via 14 is a connecting member for electrically connecting a first stripline 13 and an adjustment circuit for, for example, adjusting the phase and the amplitude of signals.

A via 16 is a connecting member for electrically connecting a second stripline 15 and an adjustment circuit for, for example, adjusting the phase and the amplitude of signals.

A slot 17 is included in the second conductor ground plane 5 at a position facing one patch antenna 3 out of the patch antennas 3-1 to 3-9.

The slot 17 excites the patch antenna 3 at the opposite position when power is fed from the first stripline 13 and the second stripline 15.

FIG. 8 is an explanatory diagram illustrating the positional relationship among a first stripline 13, a second stripline 15, and a slot 17 in the array antenna device illustrated in FIG. 7.

The explanatory diagram of FIG. 8 is a view in which the first stripline 13, the second stripline 15, and the slot 17 are viewed transparently from the lower side toward the upper side of FIG. 7.

In FIG. 7, in order to simplify the drawing, the positions where vias 14 and 16 are drawn are schematic, and the exact positions of the vias 14 and 16 are illustrated in FIG. 8.

One end of the first stripline 13 is coupled to the via 14.

The first stripline 13 is branched into two on the way, and two branch lines 13a of the first stripline 13 are disposed in parallel so as to maintain the symmetry of the first stripline 13.

One end of the second stripline 15 is coupled to the via 16.

The second stripline 15 is branched into two on the way, and two branch lines 15a of the second stripline 15 are disposed in parallel so as to maintain the symmetry of the second stripline 15.

The shape of the slot 17 is substantially cruciform, and the center 17a of the slot 17 substantially coincides with the center of a patch antenna 3 at the opposite position.

Also, at the midpoints of the two branch lines 13a, the length from a midpoint 13b at a position overlapping with the slot 17 to a tip 13c is approximately a quarter of the wavelength of a frequency of the beam in order to enhance the feeding efficiency of the slot 17.

At the midpoints of the two branch lines 15a, the length from a midpoint 15b at a position overlapping with the slot 17 to a tip 15c is approximately a quarter of the wavelength of a frequency of the beam in order to enhance the feeding efficiency of the slot 17.

Next, the operation will be described.

The first stripline 13 in the feed line portion 10 is fed with, for example, a first polarized wave, and the second stripline 15 is fed with a second polarized wave orthogonal to the first polarized wave.

The slot 17 in the feed line portion 10 has a cross slot structure in which orthogonal polarized waves can be excited, and the first polarized wave and the second polarized wave are fed with power in a contactless manner from the first stripline 13 and the second stripline 15.

The slot 17 is coupled to the patch antenna 3 at the opposite position and excites the patch antenna 3 at the opposite position when the first polarized wave and the second polarized wave are fed with power in a contactless manner from the first stripline 13 and the second stripline 15.

As a result, the slot 17 and the patch antenna 3 operate as an antenna.

Since the patch antennas 3 are excited using the slots 17 in the third embodiment, it is possible to implement an array antenna device in which cross polarization is suppressed.

Moreover, since polarized waves orthogonal to each other are fed to the first striplines 13 and the second striplines 15, a circularly polarized wave can be radiated from the patch antennas 3.

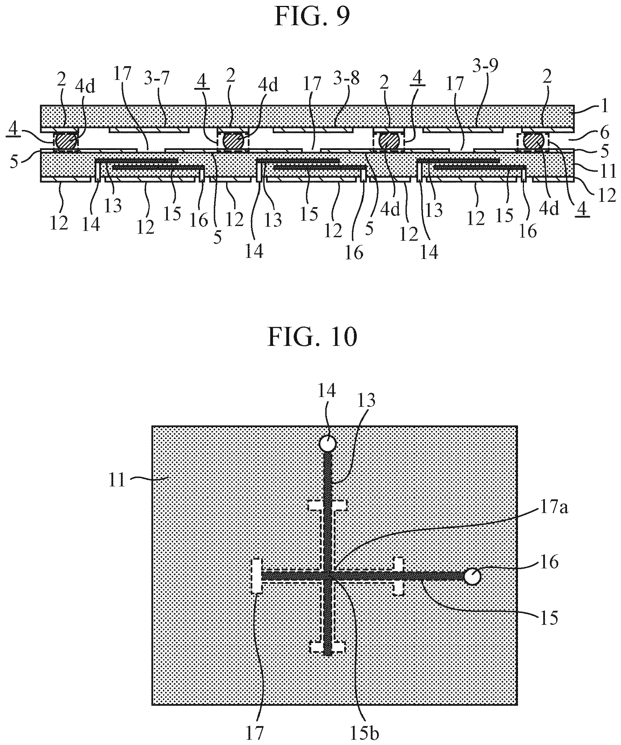

The example is illustrated in the third embodiment in which the first conductor ground plane 2 is formed on the front surface of the first dielectric substrate 1; however as illustrated in FIG. 9, the first conductor ground plane 2 may be formed on the back surface of the first dielectric substrate 1.

FIG. 9 is a cross-sectional view illustrating another array antenna device according to the third embodiment of the invention.

In FIG. 9, the same symbol as that in FIGS. 1, 4, and 7 represents the same or a corresponding part.

Even in a case where the first conductor ground plane 2 is formed on the back surface of the first dielectric substrate 1, a slot 17 can excite a patch antenna 3 at the opposite position like in the case where the first conductor ground plane 2 is formed on the front surface of the first dielectric substrate 1.

The example has been illustrated in the third embodiment in which the first stripline 13 and the second stripline 15 are each branched into two on the way; however, the present invention is not limited to those branching into two, and a first stripline 13 and a second stripline 15 may be linear as illustrated in FIG. 10.

FIG. 10 is an explanatory diagram illustrating the positional relationship among a first stripline 13, a second stripline 15, and a slot 17.

In FIG. 10, the example is illustrated in which the first stripline 13 and the second stripline 15 are disposed in such a manner that each of a midpoint 13b of the first stripline 13 and a midpoint 15b of the second stripline 15 coincides with the center 17a of the slot 17.

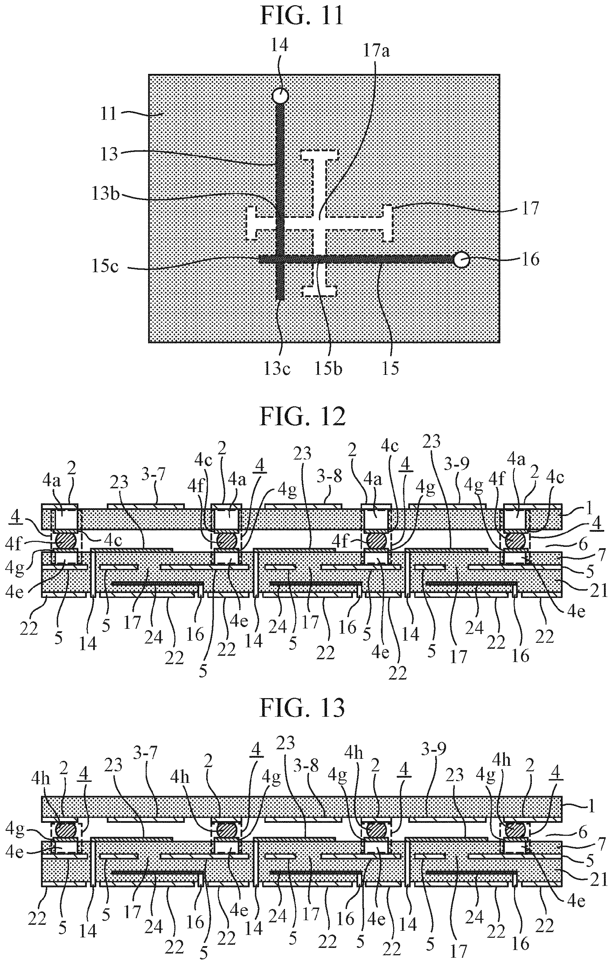

However, this is merely an example, and for example as illustrated in FIG. 11, a first stripline 13 and a second stripline 15 may be disposed in such a manner that each of a midpoint 13b of the first stripline 13 and a midpoint 15b of the second stripline 15 is offset from the center 17a of a slot 17.

FIG. 11 is an explanatory diagram illustrating the positional relationship among the first stripline 13, the second stripline 15, and the slot 17.

Fourth Embodiment

In a fourth embodiment, an array antenna device including first striplines 23, second striplines 24, and slots 17 as feed line portions will be described.

FIG. 12 is a cross-sectional view illustrating an array antenna device according to the fourth embodiment of the present invention.

A plan view of the array antenna device of the fourth embodiment is illustrated in FIG. 1 as in the first embodiment.

In FIG. 12, the same symbol as that in FIGS. 1 and 5 represents the same or a corresponding part and thus description thereof is omitted.

A third dielectric substrate 21 is disposed on, of the two planes of a second conductor ground plane 5, a plane opposite to the plane to which conductive members 4 are coupled.

A third conductor ground plane 22 is a ground plane of copper foil disposed on, of the two planes of the third dielectric substrate 21, a plane opposite to the plane on which the second conductor ground plane 5 is disposed.

Of the two planes of a second dielectric substrate 7, a first stripline 23 is provided at a position facing one patch antenna 3 out of the patch antennas 3-1 to 3-9 on a plane opposite to the plane on which the second conductor ground plane 5 is disposed.

A second stripline 24 is provided at a position facing one patch antenna 3 out of the patch antennas 3-1 to 3-9 inside the third dielectric substrate 21.

The positional relationship among a first stripline 23, a second stripline 24, and a slot 17 in the array antenna device illustrated in FIG. 12 is represented by FIG. 8, 10, or 11 as in the third embodiment.

Next, the operation will be described.

A first stripline 23 in a feed line portion is fed with, for example, a first polarized wave, and a second stripline 24 is fed with a second polarized wave orthogonal to the first polarized wave.

A slot 17 in the feed line portion has a cross slot structure in which the polarized waves orthogonal to each other can be excited, and the first polarized wave and the second polarized wave are fed with power in a contactless manner from the first stripline 23 and the second stripline 24.

The slot 17 is coupled to a patch antenna 3 at the opposite position and excites the patch antenna 3 at the opposite position when the first polarized wave and the second polarized wave are fed with power in a contactless manner from the first stripline 23 and the second stripline 24.

As a result, the slot 17 and the patch antenna 3 operate as an antenna.

Since the patch antennas 3 are excited using the slots 17 in the fourth embodiment, it is possible to implement an array antenna device in which cross polarization is suppressed.

Moreover, since polarized waves orthogonal to each other are fed to the first striplines 23 and the second striplines 24, a circularly polarized wave can be radiated from the patch antennas 3.

The example is illustrated in the fourth embodiment in which the first conductor ground plane 2 is formed on the front surface of the first dielectric substrate 1; however as illustrated in FIG. 13, the first conductor ground plane 2 may be formed on the back surface of the first dielectric substrate 1.

FIG. 13 is a cross-sectional view illustrating another array antenna device according to the fourth embodiment of the invention.

In FIG. 13, the same symbol as that in FIGS. 1, 6, and 12 represents the same or a corresponding part. Even in a case where the first conductor ground plane 2 is formed on the back surface of the first dielectric substrate 1, a slot 17 can excite a patch antenna 3 at the opposite position like in the case where the first conductor ground plane 2 is formed on the front surface of the first dielectric substrate 1.

Fifth Embodiment

In a fifth embodiment, an array antenna device including an adjustment circuit 32 for adjusting the phase and the amplitude of signals transmitted or received by patch antennas 3-1 to 3-9 will be described.

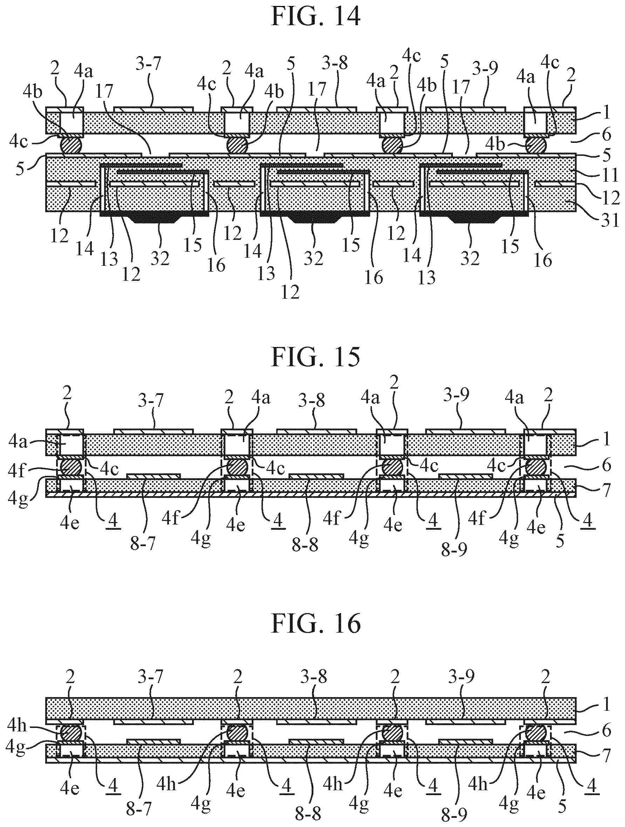

FIG. 14 is a cross-sectional view illustrating an array antenna device according to the fifth embodiment of the present invention.

A plan view of the array antenna device of the fifth embodiment is illustrated in FIG. 1 as in the first embodiment.

In FIG. 14, the same symbol as that in FIGS. 1, 2, and 7 represents the same or a corresponding part and thus description thereof is omitted.

A third dielectric substrate 31 is disposed on, of the two planes of a third conductor ground plane 12, a plane opposite to the plane on which a second dielectric substrate 11 is disposed.

An adjustment circuit 32 is disposed on, of the two planes of the third dielectric substrate 31, a plane opposite to the plane on which the third conductor ground plane 12 is disposed and is electrically coupled to a first stripline 13 via a via 14 and to a second stripline 15 via a via 16.

The adjustment circuit 32 is an integrated circuit (IC) for adjusting the phase and the amplitude of a signal transmitted or received by one patch antenna 3 out of patch antennas 3-1 to 3-9 that is provided at the opposite position.

The example is illustrated in FIG. 14 in which the first conductor ground plane 2 is formed on the front surface of the first dielectric substrate 1; however as illustrated in FIG. 9, adjustment circuits 32 may be provided in the array antenna device in which the first conductor ground plane 2 is used in the back surface of the first dielectric substrate 1.

Moreover, as illustrated in FIGS. 12 and 13, adjustment circuits 32 may be used in the array antenna device including the first striplines 23, the second striplines 24, and the slots 17 as the feed line portions.

Since the array antenna device illustrated in FIGS. 12 and 13 includes the first dielectric substrate 1, the second dielectric substrate 7, and the third dielectric substrate 21, the third dielectric substrate 31 illustrated in FIG. 14 is regarded as a fourth dielectric substrate.

An adjustment circuit 32 is electrically coupled to a first stripline 23 via a via 14 and is electrically coupled to a second stripline 24 via a via 16.

With the array antenna device including the adjustment circuits 32, an array antenna device capable of beam scanning in a desired direction can be implemented.

Sixth Embodiment

In a sixth embodiment, each of the patch antennas 3-1 to 3-9 formed in a first conductor ground plane 2 is a first patch antenna.

In the sixth embodiment, an array antenna device will be described in which second patch antennas 8-1 to 8-9 are provided on, of the two planes of a second dielectric substrate 7, a plane to which a plurality of conductive members 4 is coupled.

FIG. 15 is a cross-sectional view illustrating an array antenna device according to the sixth embodiment of the present invention.

A plan view of the array antenna device of the sixth embodiment is illustrated in FIG. 1 as in the first embodiment.

In FIG. 15, the same symbol as that in FIGS. 1, 5, and 6 represents the same or a corresponding part and thus description thereof is omitted.

The second patch antennas 8-1 to 8-9 are provided on, of the two planes of the second dielectric substrate 7, the plane to which the plurality of conductive members 4 is coupled.

Only the second patch antennas 8-7 to 8-9 are illustrated in FIG. 15, and illustration of the second patch antennas 8-1 to 8-6 is omitted.

The second patch antennas 8-1 to 8-9 are disposed at positions overlapping with the patch antennas 3-1 to 3-9, respectively, when viewed from the first dielectric substrate 1 toward the second dielectric substrate 7 side.

The second patch antennas 8-1 to 8-9 perform multiple resonance with the patch antennas 3-1 to 3-9, respectively.

Since the array antenna device of the sixth embodiment includes the second patch antennas 8-1 to 8-9, the resonance frequency of the antenna is expanded than that of the array antenna device of the first embodiment. Therefore, the array antenna device of the sixth embodiment is capable of performing beam scanning at a wide angle over a broadband as compared with the array antenna device of the first embodiment.

In the array antenna device illustrated in FIG. 15, the second patch antennas 8-1 to 8-9 are used in the array antenna device in which a first conductor ground plane 2 is provided on the front surface of the first dielectric substrate 1.

However, this is merely an example, and the second patch antennas 8-1 to 8-9 may be used in the array antenna device in which the first conductor ground plane 2 is formed on the back surface of the first dielectric substrate 1 as illustrated in FIG. 16.

FIG. 16 is a cross-sectional view illustrating another array antenna device according to the sixth embodiment of the invention.

Seventh Embodiment

In a seventh embodiment, an array antenna device will be described in which an air layer 6 is a first air layer, third connection conductors 4f are first spacers, and second spacers for forming a second air layer 9 between a second conductor ground plane 5 and a second dielectric substrate 7 are included.

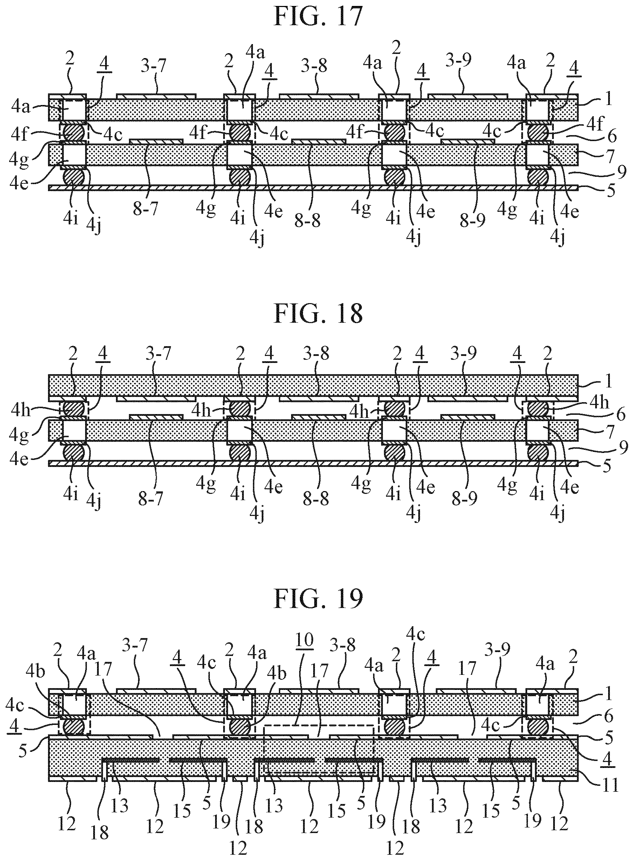

FIG. 17 is a cross-sectional view illustrating an array antenna device according to the seventh embodiment of the present invention.

A plan view of the array antenna device of the seventh embodiment is illustrated in FIG. 1 as in the first embodiment.

In FIG. 17, the same symbol as that in FIGS. 1 and 15 represents the same or a corresponding part and thus description thereof is omitted.

Fourth connection conductors 4i function as the second spacers that form the second air layer 9 between the second conductor ground plane 5 and the second dielectric substrate 7.

A land 4j is a portion where a second connection conductor 4e and the fourth connection conductor 4i are coupled by solder.

Since the array antenna device of the seventh embodiment includes the second patch antennas 8-1 to 8-9, the resonance frequency of the antenna is expanded than that of the array antenna device of the first embodiment. Therefore, the array antenna device of the seventh embodiment is capable of performing beam scanning at a wide angle over a wide band as compared with the array antenna device of the first embodiment.

Furthermore, since the array antenna device of the seventh embodiment includes the second air layer 9, better axial ratio characteristics in the wide-angle direction can be obtained than in the array antenna device of the first embodiment.

In the array antenna device illustrated in FIG. 17, the second air layer 9 is formed in the array antenna device in which a first conductor ground plane 2 is provided on the front surface of a first dielectric substrate 1.

However, this is merely an example, and the second air layer 9 may be formed in the array antenna device in which the first conductor ground plane 2 is formed on the back surface of the first dielectric substrate 1 as illustrated in FIG. 18.

FIG. 18 is a cross-sectional view illustrating another array antenna device according to the seventh embodiment of the invention.

Eighth Embodiment

In the eighth embodiment, an array antenna device will be described in which first striplines 13 and second striplines 15 are wired in the same plane, and each of the first striplines 13 and the second striplines 15 excites patch antennas 3-1 to 3-9.

FIG. 19 is a cross-sectional view illustrating an array antenna device according to the eighth embodiment of the present invention.

A plan view of the array antenna device of the eighth embodiment is illustrated in FIG. 1 as in the first embodiment. In FIG. 19, the same symbol as that in FIGS. 1, 7, and 9 represents the same or a corresponding part and thus description thereof is omitted.

In the array antenna device illustrated in FIG. 19, first striplines 13 and second striplines 15 are wired on the same plane inside a second dielectric substrate 11.

One end of a via 18 is coupled to a first stripline 13, and the other end protrudes from the array antenna device.

One end of a via 19 is coupled to a second stripline 15, and the other end protrudes from the array antenna device.

The vias 18 and the vias 19 have the same length.

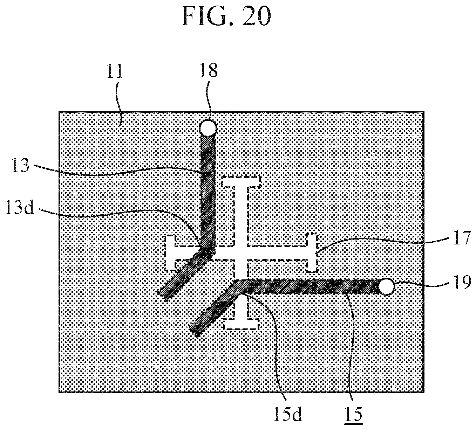

FIG. 20 is a plan view illustrating the positional relationship between a first stripline 13 and a second stripline 15.

In FIG. 20, the first stripline 13 is disposed in such a manner that a midpoint 13d overlaps with a slot extending in the lateral direction in the drawing of a slot 17.

The second stripline 15 is also disposed in such a manner that a midpoint 15d overlaps with a slot extending in the longitudinal direction in the drawing of a slot 17 in FIG. 20.

Since the first striplines 13 and the second striplines 15 are wired on the same plane in the array antenna device of the eighth embodiment, the impedance characteristics of the antenna seen from the input side are substantially the same. Therefore, the array antenna device of the eighth embodiment has better symmetry and better axial ratio characteristics than the array antenna device of the third and fourth embodiments.

INDUSTRIAL APPLICABILITY

The present invention is suitable for an array antenna device including a plurality of patch antennas.

REFERENCE SIGNS LIST

1: First dielectric substrate, 2: First conductor ground plane, 2a: Conductor-cut-out portion, 3-1 to 3-9: Patch antenna, 4: Conductive member, 4a: First connection conductor, 4b: Second connection conductor, 4c: Land, 4d: First connection conductor, 4e: Second connection conductor, 4f: Third connection conductor, 4g: Land, 4h: First connection conductor, 4i: Fourth connection conductor, 4j: Land, 5: Second conductor ground plane, 6: Air layer, 7: Second dielectric substrate, 8-1 to 8-9: Second patch antenna, 9: Second air layer, 10: Feed line portion, 11: Second dielectric substrate, 12: Third conductor ground plane, 13: First stripline, 13a: Branch line, 13b: Midpoint, 13c: Tip, 13d: Midpoint, 14, 16: Via, 15: Second stripline, 15a: Branch line, 15b: Midpoint, 15c: Tip, 15d: Midpoint, 17: Slot, 17a: Slot center, 18, 19: Via, 21: Third dielectric substrate, 22: Third conductor ground plane, 23: First stripline, 24: Second stripline, 31: Third dielectric substrate, 32: Adjustment circuit.

**Claims**

1. An array antenna device comprising:

   a first dielectric substrate (1) provided with a first conductor ground plane (2) on a front surface or a back surface thereof;
   a plurality of patch antennas (3-1 to 3-9) provided in the first conductor ground plane (2), each of the patch antennas (3-1 to 3-9) having a circular shape;
   a plurality of conductive members (4), ends of which are connected to the first conductor ground plane (2) to surround each of the patch antennas (3-1 to 3-9) individually and the conductive members (4) surrounding a respective patch antenna (3-1 to 3-9) are equidistant from a center of said patch antenna (3-1 to 3-9); and
   a second conductor ground plane (5) connected to each of other ends of the conductive members (4),
   wherein the first conductor ground plane (2) is provided on one of,

      a) the front surface of the first dielectric substrate (1), a part of the plurality of conductive members (4) penetrates the first dielectric substrate (1), and a remaining part of the plurality of conductive members (4) functions as spacers for providing an air layer (6) between the first dielectric substrate (1) and the second conductor ground plane (5), and
      b) the back surface of the first dielectric substrate (1), the plurality of conductive members (4) functions as spacers for providing an air layer (6) between the first conductor ground plane (2) and the second conductor ground plane (5),

   wherein the conductive member adjacent to at least two or more patch antennas among the plurality of patch antennas (3-1 to 3-9), out of the plurality of conductive members (4), is disposed at a position equidistant from a center of each of the at least two or more patch antennas adjacent to each other.

2. The array antenna device according to claim 1, further comprising:

   a second dielectric substrate (7) disposed between the first dielectric substrate (1) and the second conductor ground plane (5) in a case where the first conductor ground plane (2) is provided on the front surface of the first dielectric substrate (1), the second dielectric substrate (7) being disposed between the first conductor ground plane (2) and the second conductor ground plane (5) in a case where the first conductor ground plane (2) is provided on the back surface of the first dielectric substrate (1),
   wherein in the case where the first conductor ground plane (2) is provided on the front surface of the first dielectric substrate (1), a part of the plurality of conductive members (4) penetrates the first and second dielectric substrates, and the remaining part of the plurality of conductive members (4) functions as spacers for providing an air layer (6) between the first dielectric substrate (1) and the second dielectric substrate (7), and
   in the case where the first conductor ground plane (2) is provided on the back surface of the first dielectric substrate (1), a part of the plurality of conductive members penetrates the second dielectric substrate (7), and the remaining part of the plurality of conductive members (4) functions as spacers for providing an air layer (6) between the first conductor ground plane (2) and the second dielectric substrate (7).

3. The array antenna device according to claim 1,

   wherein the first conductor ground plane (2) is provided on the front surface of the first dielectric substrate (1), each of the conductive members (4) comprises:

      a first connection conductor provided so as to penetrate the first dielectric substrate (1) and connected to the first conductor ground plane (2) at one end thereof at a position surrounding one of the patch antennas (3-1 to 3-9); and

a second connection conductor (4b, 4e) electrically connecting another end of the first connection conductor and the second conductor ground plane (5), and

the second connection conductor (4b, 4e) functions as a spacer for providing an air layer (6) between the first dielectric substrate (1) and the second conductor ground plane (5).

4. The array antenna device according to claim 1,

wherein, when the first conductor ground plane (2) is provided on the back surface of the first dielectric substrate (1),

each of the conductive members (4) is a first connection conductor (4a, 4d, 4h) connected to the first conductor ground plane (2) at one end thereof and connected to the second conductor ground plane (5) at another end thereof at a position surrounding one of the patch antennas (3-1 to 3-9), and

the first connection conductor (4a, 4d, 4h) functions as a spacer for providing an air layer (6) between the first conductor ground plane (2) and the second conductor ground plane (5).

5. The array antenna device according to claim 2,

wherein, when the first conductor ground plane (2) is provided on the front surface of the first dielectric substrate (1),

each of the conductive members (4) comprises:

a first connection conductor (4a, 4d, 4h) provided to penetrate the first dielectric substrate (1) and connected to the first conductor ground plane (2) at one end thereof at a position surrounding one of the patch antennas (3-1 to 3-9);

a second connection conductor (4b, 4e) provided to penetrate the second dielectric substrate (7) and connected to the second conductor ground plane (5) at one end thereof; and

a third connection conductor (4f) electrically connecting another end of the first connection conductor (4a, 4d, 4h) and another end of the second connection conductor (4b, 4e), and

the third connection conductor (4f) functions as a spacer for providing an air layer (6) between the first dielectric substrate (1) and the second dielectric substrate (7).

6. The array antenna device according to claim 2,

wherein, when the first conductor ground plane (2) is provided on the back surface of the first dielectric substrate (1),

each of the conductive members (4) comprises:

a first connection conductor (4a, 4d, 4h) connected to the first conductor ground plane (2) at one end thereof at a position surrounding one of the patch antennas (3-1 to 3-9); and

a second connection conductor (4b, 4e) provided so as to penetrate the second dielectric substrate (7) and connected to the second conductor ground plane (5) at one end thereof, and

the first connection conductor (4a, 4d, 4h) functions as a spacer for providing an air layer (6) between the first conductor ground plane (2) and the second dielectric substrate (7).

7. The array antenna device according to claim 1, further comprising:

a second dielectric substrate (7) disposed on, of two planes of the second conductor ground plane (5), a plane opposite to the plane to which the plurality of conductive members (4) is connected;

a third conductor ground plane disposed on, of two planes of the second dielectric substrate (7), a plane opposite to the plane on which the second conductor ground plane (5) is provided;

a plurality of first and second striplines disposed inside the second dielectric substrate (7) at positions facing the patch antennas (3-1 to 3-9) individually; and

a plurality of slots (17) provided in the second conductor ground plane (5) (5) at positions facing the patch antennas (3-1 to 3-9) individually,

wherein each of the slots (17) excites one of the patch antennas (3-1 to 3-9) provided at an opposite position when power is fed from one of the first striplines (13, 23) and one of the second striplines (15, 24).

8. The array antenna device according to claim 7, further comprising:

a third dielectric substrate disposed on, of two planes of the third conductor ground plane, a plane opposite to the plane on which the second dielectric substrate (7) is disposed; and
a plurality of adjustment circuits (32) for adjusting a phase and an amplitude of a signal transmitted or received by one of the patch antennas (3-1 to 3-9), the plurality of adjustment circuits (32) disposed on, of two planes of the third dielectric substrate, a plane opposite to the plane on which the third conductor ground plane is disposed, each of the adjustment circuits (32) electrically connected to each of the first and second striplines (15, 24) provided at positions opposite to one of the patch antennas (3-1 to 3-9).

9. The array antenna device according to claim 2, further comprising:

a third dielectric substrate disposed on, of two planes of the second conductor ground plane (5), a plane opposite to the plane on which the second dielectric substrate (7) is disposed;
a third conductor ground plane disposed on, of two planes of the third dielectric substrate, a plane opposite to the plane on which the second conductor ground plane (5) is disposed;
a plurality of first striplines (13, 23) provided on, of two planes of the second dielectric substrate (7), a plane opposite to the plane on which the second conductor ground plane (5) is disposed at positions facing the patch antennas (3-1 to 3-9) individually;
a plurality of second striplines (15, 24) disposed inside the third dielectric substrate at positions facing the patch antennas (3-1 to 3-9) individually; and
a plurality of slots (17) formed inside the second conductor ground plane (5) at positions facing the patch antennas (3-1 to 3-9) individually,
wherein each of the slots (17) is configured to excite one of the patch antennas (3-1 to 3-9) provided at an opposite position when power is fed from one of the first striplines (13, 23) and one of the second striplines (15, 24).

10. The array antenna device according to claim 9, further comprising:

a fourth dielectric substrate disposed on, of two planes of the third conductor ground plane, a plane opposite to the plane on which the third dielectric substrate is disposed; and
a plurality of adjustment circuits (32) for adjusting a phase and an amplitude of a signal transmitted or received by one of the patch antennas (3-1 to 3-9), the plurality of adjustment circuits (32) disposed on, of two planes of the fourth dielectric substrate, a plane opposite to the plane on which the third conductor ground plane is disposed, each of the adjustment circuits (32) electrically connected to each of the first and second striplines provided at positions opposite to one of the patch antennas (3-1 to 3-9).

11. The array antenna device according to claim 2,

wherein each of the patch antennas (3-1 to 3-9) provided in the first conductor ground plane (2) is a first patch antenna, and
a plurality of second patch antennas (3-1 to 3-9) are provided on, of two planes of the second dielectric substrate (7), a plane to which the plurality of conductive members (4) is connected.

12. The array antenna device according to claim 11,

wherein the air layer (6) is a first air layer,
the spacers are first spacers, and
the array antenna device further comprises second spacers for forming a second air layer (9) between the second conductor ground plane (5) and the second dielectric substrate (7).

13. The array antenna device according to claim 2, wherein first striplines (13, 23) and second striplines (15, 24) are wired on a same plane inside the second dielectric substrate (7), and each of the first striplines (13, 23) and the second striplines (15, 24) is configured to excite the patch antennas (3-1 to 3-9).

**Patentansprüche**

1. Antennengruppeneinrichtung, umfassend:

ein erstes dielektrisches Substrat (1), das mit einer ersten leitenden Grundplatte (2) auf einer vorderen Oberfläche oder einer hinteren Oberfläche versehen ist;

eine Vielzahl von Patch-Antennen (3-1 bis 3-9), die in der ersten leitenden Grundplatte (2) vorgesehen sind, wobei jede der Patch-Antennen (3-1 bis 3-9) eine Kreisform aufweist;

eine Vielzahl von leitenden Elementen (4), von denen Enden mit der ersten leitenden Grundplatte (2) verbunden sind, um jede der Patch-Antennen (3-1 bis 3-9) einzeln zu umgeben, wobei die leitenden Elemente (4), die eine jeweilige Patch-Antenne (3-1 bis 3-9) umgeben, zu einem Zentrum der Patch-Antenne (3-1 bis 3-9) äquidistant sind; und

eine zweite leitende Grundplatte (5), die mit jedem von anderen Enden der leitenden Elemente (4) verbunden ist, wobei die erste leitende Grundplatte (2) auf einem der folgenden vorgesehen ist,

a) der vorderen Oberfläche des ersten dielektrischen Substrats (1), wobei ein Teil der Vielzahl von leitenden Elementen (4) in das erste dielektrische Substrat (1) eindringt und ein verbleibender Teil der Vielzahl von leitenden Elementen (4) als Abstandshalter fungiert, um eine Luftschicht (6) zwischen dem ersten dielektrischen Substrat (1) und der zweiten leitenden Grundplatte (5) bereitzustellen, und

b) der hinteren Oberfläche des ersten dielektrischen Substrats (1), wobei die Vielzahl von leitenden Elementen (4) als Abstandshalter fungieren, um eine Luftschicht (6) zwischen der ersten leitenden Grundplatte (2) und der zweiten leitenden Grundplatte (5) bereitzustellen,

wobei das leitende Element aus der Vielzahl von leitenden Elementen (4), das zu mindestens zwei oder mehr Patch-Antennen aus der Vielzahl von Patch-Antennen (3-1 bis 3-9) benachbart ist, an einer Position angeordnet ist, welche zu einem Zentrum von jeder der mindestens zwei oder mehr Patch-Antennen, die zueinander benachbart sind, äquidistant angeordnet ist.

2. Antennengruppeneinrichtung nach Anspruch 1, ferner umfassend:

ein zweites dielektrisches Substrat (7), das zwischen dem ersten dielektrischen Substrat (1) und der zweiten leitenden Grundplatte (5) in einem Fall angeordnet ist, in dem die erste leitende Grundplatte (2) auf der vorderen Oberfläche des ersten dielektrischen Substrats (1) vorgesehen ist, und wobei das zweite dielektrische Substrat (7) zwischen der erstenleitenden Grundplatte (2) und der zweiten leitenden Grundplatte (5) in einem Fall angeordnet ist, in dem die ersteleitende Grundplatte (2) auf der hinteren Oberfläche des ersten dielektrischen Substrats (1) vorgesehen ist,

wobei in dem Fall, in dem die erste leitende Grundplatte (2) auf der vorderen Oberfläche des ersten dielektrischen Substrats (1) angeordnet ist, ein Teil der Vielzahl von leitenden Elementen (4) in das erste und das zweite dielektrische Substrat eindringt, und der verbleibende Teil der Vielzahl von leitenden Elementen (4) als Abstandshalter zum Bereitstellen einer Luftschicht (6) zwischen dem ersten dielektrischen Substrat (1) und dem zweiten dielektrischen Substrat (7) fungiert, und

in dem Fall, in dem die erste leitende Grundplatte (2) auf der Rückseite des ersten dielektrischen Substrats (1) angeordnet ist, ein Teil der Vielzahl von leitenden Elementen in das zweite dielektrische Substrat (7) eindringt, und der verbleibende Teil der Vielzahl von leitenden Elementen (4) als Abstandshalter zum Bereitstellen einer Luftschicht (6) zwischen der ersten leitenden Grundplatte (2) und dem zweiten dielektrischen Substrat (7) funktioniert.

3. Antennengruppeneinrichtung nach Anspruch 1,

wobei die erste leitende Grundplatte (2) auf der vorderen Oberfläche des ersten dielektrischen Substrats (1) vorgesehen ist,

jedes von den leitenden Elementen (4) umfasst:

einen ersten Verbindungsleiter, der vorgesehen ist, um in das erste dielektrische Substrat (1) einzudringen, und der mit der ersten leitenden Grundplatte (2) an einem Ende davon an einer Position verbunden ist, die eine der Patch-Antennen (3-1 bis 3-9) umgibt; und

einen zweiten Verbindungsleiter (4b, 4e), der ein anderes Ende des ersten Verbindungsleiters und die zweite leitende Grundplatte (5) elektrisch verbindet, und

der zweite Verbindungsleiter (4b, 4e) als ein Abstandshalter fungiert, um eine Luftschicht (6) zwischen dem ersten dielektrischen Substrat (1) und der zweiten leitenden Grundplatte (5) bereitzustellen.

4. Antennengruppeneinrichtung nach Anspruch 1,

wobei, wenn die erste leitende Grundplatte (2) auf der hinteren Oberfläche des ersten dielektrischen Substrats (1) vorgesehen ist,

jedes der leitenden Elemente (4) ein erster Verbindungsleiter (4a, 4d, 4h) ist, der mit der leitenden Grundplatte (2) an einem Ende davon verbunden ist, und mit der zweiten leitenden Grundplatte (5) an einem anderen Ende davon an einer Position verbunden ist, die eine der Patch-Antennen (3-1 bis 3-9) umgibt, und

der erste Verbindungsleiter (4a, 4d, 4h) als ein Abstandshalter fungiert, um eine Luftschicht (6) zwischen der ersten leitenden Grundplatte (2) und der zweiten leitenden Grundplatte(5) bereitzustellen.

5.  Antennengruppeneinrichtung nach Anspruch 2,

wobei, wenn die erste leitende Grundplatte (2) auf der vorderen Oberfläche des ersten dielektrischen Substrats (1) vorgesehen ist,

jedes von den leitenden Elementen (4) umfasst:

einen ersten Verbindungsleiter (4a, 4d, 4h), der vorgesehen ist, um in das erste dielektrische Substrat (1) einzudringen, und der mit der ersten leitenden Grundplatte (2) an einem Ende davon an einer Position verbunden ist, die eine der Patch-Antennen (3-1 bis 3-9) umgibt;

einen zweiten Verbindungsleiter (4b, 4e), der vorgesehen ist, um in das zweite dielektrische Substrat (7) einzudringen, und der mit der zweiten leitenden Grundplatte (5) an einem Ende davon verbunden ist; und

einen dritten Verbindungsleiter (4f), der ein anderes Ende des ersten Verbindungsleiters (4a, 4d, 4h) und ein anderes Ende des zweiten Verbindungsleiters (4b, 4e) elektrisch verbindet, und

der dritte Verbindungsleiter (4f) als ein Abstandshalter zur Bereitstellung einer Luftschicht (6) zwischen dem ersten dielektrischen Substrat (1) und dem zweiten dielektrischen Substrat (7) fungiert.

6.  Antennengruppeneinrichtung nach Anspruch 2,

wobei, wenn die erste leitende Grundplatte (2) auf der hinteren Oberfläche des ersten dielektrischen Substrats (1) vorgesehen ist,

jedes von den leitenden Elementen (4) umfasst:

einen ersten Verbindungsleiter (4a, 4d, 4h), der mit der ersten leitenden Grundplatte (2) an einem Ende davon an einer Position verbunden ist, die eine der Patch-Antennen (3-1 bis 3-9) umgibt; und

einen zweiten Verbindungsleiter (4b, 4e), der vorgesehen ist, um in das zweite dielektrische Substrat (7) einzudringen, und mit der zweiten leitenden Grundplatte (5) an einem Ende davon verbunden ist, und

der erste Verbindungsleiter (4a, 4d, 4h) als ein Abstandshalter fungiert, um eine Luftschicht (6) zwischen der ersten leitenden Grundplatte (2) und dem zweiten dielektrischen Substrat (7) bereitzustellen.

7.  Antennengruppeneinrichtung nach Anspruch 1, ferner umfassend:

ein zweites dielektrisches Substrat (7), das, aus zwei Ebenen der zweiten leitenden Grundplatte (5), auf einer Ebene angeordnet ist, die der Ebene gegenüberliegt, mit der die Vielzahl von leitenden Elementen (4) verbunden sind;

eine dritte Leiter-Masseebene, die, aus zwei Ebenen des zweiten dielektrischen Substrats (7), auf einer Ebene angeordnet ist, die der Ebene gegenüberliegt, auf der die zweite Leiter-Masseebene (5) vorgesehen ist;

eine Vielzahl von ersten und zweiten Streifenleitungen, die innerhalb des zweiten dielektrischen Substrats (7) an Positionen angeordnet sind, die den Patch-Antennen (3-1 bis 3-9) einzeln zugewandt sind; und

eine Vielzahl von Schlitzen (17), die in der zweiten leitenden Grundplatte (5) an Positionen vorgesehen sind, die den Patch-Antennen (3-1 bis 3-9) einzeln zugewandt sind,

wobei jeder der Schlitze (17) eine der Patch-Antennen (3-1 bis 3-9) anregt, die an einer gegenüberliegenden Position vorgesehen sind, wenn Energie von einer der ersten Streifenleitungen (13, 23) und einer der zweiten Streifenleitungen (15, 24) zugeführt wird.

8.  Antennengruppeneinrichtung nach Anspruch 7, ferner umfassend:

ein drittes dielektrisches Substrat, das, aus zwei Ebenen der dritten leitenden Grundplatte, auf einer Ebene angeordnet ist, die der Ebene gegenüberliegt, auf der das zweite dielektrische Substrat (7) angeordnet ist; und

eine Vielzahl von Einstellschaltungen (32) zum Einstellen einer Phase und einer Amplitude eines von einer der Patch-Antennen (3-1 bis 3-9) übertragenen oder empfangenen Signals, wobei die Vielzahl von Einstellschaltungen (32), aus zwei Ebenen des dritten dielektrischen Substrats, auf einer Ebene angeordnet sind, die der Ebene gegenüberliegt, auf der die dritte leitende Grundplatte angeordnet ist, wobei jede der Einstellschaltungen (32) elektrisch mit jeder der ersten und zweiten Streifenleitungen (15, 24) verbunden ist, die an Positionen vorgesehen sind, die einer der Patch-Antennen (3-1 bis 3-9) gegenüberliegen.

9. Antennengruppeneinrichtung nach Anspruch 2, ferner umfassend:

ein drittes dielektrisches Substrat, das, aus zwei Ebenen der zweiten Leiter-Masseebene (5), auf einer Ebene angeordnet ist, die der Ebene gegenüberliegt, auf der das zweite dielektrische Substrat (7) angeordnet ist;
eine dritte leitende Grundplatte, die, aus zwei Ebenen des dritten dielektrischen Substrats, auf einer Ebene angeordnet ist, die der Ebene gegenüberliegt, auf der die zweite leitende Grundplatte (5) angeordnet ist;
eine Vielzahl von ersten Streifenleitungen (13, 23), die, aus zwei Ebenen des zweiten dielektrischen Substrats (7) auf einer Ebene angeordnet sind, die der Ebene gegenüberliegt, auf der die zweite leitende Grundplatte (5) an Positionen angeordnet ist, die den Patch-Antennen (3-1 bis 3-9) einzeln zugewandt sind;
eine Vielzahl von zweiten Streifenleitungen (15, 24), die innerhalb des dritten dielektrischen Substrats an Positionen angeordnet sind, die den Patch-Antennen (3-1 bis 3-9) einzeln zugewandt sind; und
eine Vielzahl von Schlitzen (17), die in der zweiten leitenden Grundplatte (5) an Positionen vorgesehen sind, die den Patch-Antennen (3-1 bis 3-9) einzeln zugewandt sind,
wobei jeder der Schlitze (17) dazu eingerichtet ist, eine der Patch-Antennen (3-1 bis 3-9), die an einer gegenüberliegenden Position vorgesehen sind, anzuregen, wenn Energie von einer der ersten Streifenleitungen (13, 23) und einer der zweiten Streifenleitungen (15, 24) zugeführt wird.

10. Antennengruppeneinrichtung nach Anspruch 9, ferner umfassend:

ein viertes dielektrisches Substrat, das, aus zwei Ebenen der dritten leitenden Grundplatte, auf einer Ebene angeordnet ist, die der Ebene gegenüberliegt, auf der das dritte dielektrische Substrat angeordnet ist; und
eine Vielzahl von Einstellschaltungen (32) zum Einstellen einer Phase und einer Amplitude eines Signals, das von einer der Patch-Antennen (3-1 bis 3-9) übertragen oder empfangen wird, wobei die Vielzahl von Einstellschaltungen (32), aus zwei Ebenen des vierten dielektrischen Substrats, auf einer Ebene angeordnet sind, die der Ebene gegenüberliegt, auf der die dritte leitende Grundplatte angeordnet ist, wobei jede der Einstellschaltungen (32) elektrisch mit jeder der ersten und zweiten Streifenleitungen verbunden ist, die an Positionen vorgesehen sind, die einer der Patch-Antennen (3-1 bis 3-9) gegenüberliegen.

11. Antennengruppeneinrichtung nach Anspruch 2,

wobei jede der Patch-Antennen (3-1 bis 3-9), die in der ersten leitenden Grundplatte (2) vorgesehen sind, eine erste Patch-Antenne ist, und
eine Vielzahl von zweiten Patch-Antennen (3-1 bis 3-9), aus zwei Ebenen des zweiten dielektrischen Substrats (7), auf einer Ebene angeordnet sind, mit der die Vielzahl von leitenden Elementen (4) verbunden sind.

12. Antennengruppeneinrichtung nach Anspruch 11,

wobei die Luftschicht (6) eine erste Luftschicht ist,
die Abstandshalter erste Abstandshalter sind, und
die Antennengruppeneinrichtung ferner zweite Abstandshalter zum Bilden einer zweiten Luftschicht (9) zwischen der zweiten leitenden Grundplatte (5) und dem zweiten dielektrischen Substrat (7) umfasst.

13. Antennengruppeneinrichtung nach Anspruch 2, wobei erste Streifenleitungen (13, 23) und zweite Streifenleitungen (15, 24) auf einer gleichen Ebene innerhalb des zweiten dielektrischen Substrats (7) verdrahtet sind und jede der ersten Streifenleitungen (13, 23) und der zweiten Streifenleitungen (15, 24) eingerichtet sind, die Patch-Antennen (3-1 bis 3-9) anzuregen.


**Revendications**

1. Dispositif d'antenne réseau comprenant :

un premier substrat diélectrique (1) pourvu d'une première plaque de masse conductrice (2) sur sa surface avant ou sa surface arrière ;

une pluralité d'antennes à plaque (3-1 à 3-9) placées dans la première plaque de masse conductrice (2), chacune des antennes à plaque (3-1 à 3-9) ayant une forme circulaire ;

une pluralité d'éléments conducteurs (4), dont les extrémités sont reliées à la première plaque de masse conductrice (2) pour entourer chacune des antennes à plaque (3-1 à 3-9) individuellement et les éléments conducteurs (4) entourant une antenne à plaque respective (3-1 à 3-9) sont équidistants d'un centre de ladite antenne à plaque (3-1 à 3-9) ; et

une deuxième plaque de masse conductrice (5) reliée à chacune des autres extrémités des éléments conducteurs (4),

dans lequel la première plaque de masse conductrice (2) est prévue sur l'un de

a) la surface avant du premier substrat diélectrique (1), une partie de la pluralité d'éléments conducteurs (4) pénètre dans le premier substrat diélectrique (1), et une partie restante de la pluralité d'éléments conducteurs (4) fonctionne comme des entretoises pour fournir une couche d'air (6) entre le premier substrat diélectrique (1) et la deuxième plaque de masse conductrice (5), et

b) la surface arrière du premier substrat diélectrique (1), la pluralité d'éléments conducteurs (4) fonctionne comme des entretoises pour fournir une couche d'air (6) entre la première plaque de masse conductrice (2) et la deuxième plaque de masse conductrice (5),

dans lequel l'élément conducteur adjacent à au moins deux antennes à plaque ou plus parmi la pluralité d'antennes à plaque (3-1 à 3-9), sur la pluralité d'éléments conducteurs (4), est disposé à une position équidistante d'un centre de chacune des au moins deux antennes à plaque ou plus adjacentes l'une à l'autre.

2. Dispositif d'antenne réseau selon la revendication 1, comprenant en outre :

un deuxième substrat diélectrique (7) disposé entre le premier substrat diélectrique (1) et la deuxième plaque de masse conductrice (5) dans le cas où la première plaque de masse conductrice (2) se trouve sur la surface avant du premier substrat diélectrique (1), le deuxième substrat diélectrique (7) étant disposé entre la première plaque de masse conductrice (2) et la deuxième plaque de masse conductrice (5) dans un cas où la première plaque de masse conductrice (2) est disposée sur la surface arrière du premier substrat diélectrique (1),

dans lequel, dans le cas où la première plaque de masse conductrice (2) est disposée sur la surface avant du premier substrat diélectrique (1), une partie de la pluralité d'éléments conducteurs (4) pénètre dans les premier et deuxième substrats diélectriques, et la partie restante de la pluralité d'éléments conducteurs (4) fonctionne comme des entretoises pour fournir une couche d'air (6) entre le premier substrat diélectrique (1) et le deuxième substrat diélectrique (7), et

dans le cas où la première plaque de masse conductrice (2) est disposée sur la surface arrière du premier substrat diélectrique (1), une partie de la pluralité d'éléments conducteurs pénètre dans le deuxième substrat diélectrique (7), et la partie restante de la pluralité d'éléments conducteurs (4) fonctionne comme des entretoises pour fournir une couche d'air (6) entre la première plaque de masse conductrice (2) et le deuxième substrat diélectrique (7).

3. Dispositif d'antenne réseau selon la revendication 1,

dans lequel la première plaque de masse conductrice (2) est située sur la surface avant du premier substrat diélectrique (1),

chacun des éléments conducteurs (4) comprend :

un premier conducteur de connexion prévu pour pénétrer dans le premier substrat diélectrique (1) et connecté à la première plaque de masse conductrice (2) à l'une de ses extrémités à une position entourant l'une des antennes à plaque (3-1 à 3-9) ; et

un deuxième conducteur de connexion (4b, 4e) reliant électriquement une autre extrémité du premier conducteur de connexion et la deuxième plaque de masse conductrice (5), et

le deuxième conducteur de connexion (4b, 4e) sert d'entretoise pour fournir une couche d'air (6) entre le premier substrat diélectrique (1) et la deuxième plaque de masse conductrice (5).

4. Dispositif d'antenne réseau selon la revendication 1,

dans lequel, lorsque la première plaque de masse conductrice (2) est située sur la surface arrière du premier substrat diélectrique (1),
chacun des éléments conducteurs (4) est un premier conducteur de connexion (4a, 4d, 4h) relié à la première plaque de masse conductrice (2) à l'une de ses extrémités et relié à la deuxième plaque de masse conductrice (5) à l'autre de ses extrémités à une position entourant l'une des antennes à plaque (3-1 à 3-9), et le premier conducteur de connexion (4a, 4d, 4h) sert d'entretoise pour fournir une couche d'air (6) entre la première plaque de masse conductrice (2) et la deuxième plaque de masse conductrice (5).

5. Dispositif d'antenne réseau selon la revendication 2,
dans lequel, lorsque la première plaque de masse conductrice (2) est située sur la surface avant du premier substrat diélectrique (1), chacun des éléments conducteurs (4) comprend :

un premier conducteur de connexion (4a, 4d, 4h) prévu pour pénétrer dans le premier substrat diélectrique (1) et connecté à la première plaque de masse conductrice (2) à l'une de ses extrémités à une position entourant l'une des antennes à plaque (3-1 à 3-9) ;
un deuxième conducteur de connexion (4b, 4e) prévu pour pénétrer dans le deuxième substrat diélectrique (7) et connecté à la deuxième plaque de masse conductrice (5) à l'une de ses extrémités ; et
un troisième conducteur de connexion (4f) reliant électriquement une autre extrémité du premier conducteur de connexion (4a, 4d, 4h) et une autre extrémité du deuxième conducteur de connexion (4b, 4e), et
le troisième conducteur de connexion (4f) sert d'entretoise pour fournir une couche d'air (6) entre le premier substrat diélectrique (1) et le deuxième substrat diélectrique (7).

6. Dispositif d'antenne réseau selon la revendication 2,
dans lequel, lorsque la première plaque de masse conductrice (2) est située sur la surface arrière du premier substrat diélectrique (1), chacun des éléments conducteurs (4) comprend :

un premier conducteur de connexion (4a, 4d, 4h) connecté à la première plaque de masse conductrice (2) à l'une de ses extrémités à une position entourant l'une des antennes à plaque (3-1 à 3-9) ; et
un deuxième conducteur de connexion (4b, 4e) prévu de façon à pénétrer dans le deuxième substrat diélectrique (7) et connecté à la deuxième plaque de masse conductrice (5) à l'une de ses extrémités ; et
le premier conducteur de connexion (4a, 4d, 4h) sert d'entretoise pour fournir une couche d'air (6) entre la première plaque de masse conductrice (2) et le deuxième substrat diélectrique (7).

7. Dispositif d'antenne réseau selon la revendication 1, comprenant en outre :

un deuxième substrat diélectrique (7) disposé sur, parmi les deux plans de la deuxième plaque de masse conductrice (5), un plan opposé au plan auquel la pluralité d'éléments conducteurs (4) est connectée ;
une troisième plaque de masse conductrice disposée sur, parmi les deux plans du deuxième substrat diélectrique (7), un plan opposé au plan sur lequel la deuxième plaque de masse conductrice (5) est disposée ;
une pluralité de premières et de secondes lignes ruban disposées à l'intérieur du deuxième substrat diélectrique (7) à des positions faisant face aux antennes à plaque (3-1 à 3-9) individuellement ; et
une pluralité de fentes (17) prévues dans la deuxième plaque de masse conductrice (5) (5) à des positions faisant face aux antennes à plaque (3-1 à 3-9) individuellement,
dans lequel chacune des fentes (17) excite l'une des antennes à plaque (3-1 à 3-9) situées à une position opposée lorsque l'alimentation est fournie par l'une des premières lignes ruban (13, 23) et l'une des secondes lignes ruban (15, 24).

8. Dispositif d'antenne réseau selon la revendication 7, comprenant en outre :

un troisième substrat diélectrique disposé sur, parmi les deux plans de la troisième plaque de masse conductrice, un plan opposé au plan sur lequel le deuxième substrat diélectrique (7) est disposé ; et
une pluralité de circuits d'ajustement (32) pour ajuster une phase et une amplitude d'un signal émis ou reçu par l'une des antennes à plaque (3-1 à 3-9), la pluralité de circuits d'ajustement (32) disposés sur, parmi les deux plans du troisième substrat diélectrique, un plan opposé au plan sur lequel la troisième plaque de masse conductrice est disposée, chacun des circuits d'ajustement (32) étant connecté électriquement à chacune des premières et secondes lignes ruban (15, 24) disposées à des positions opposées à l'une des antennes à plaque (3-1 à 3-9).

9. Dispositif d'antenne réseau selon la revendication 2, comprenant en outre :

un troisième substrat diélectrique disposé sur, parmi les deux plans de la deuxième plaque de masse conductrice (5), un plan opposé au plan sur lequel le deuxième substrat diélectrique (7) est disposé ;

une troisième plaque de masse conductrice disposée sur, parmi les deux plans du troisième substrat diélectrique, un plan opposé au plan sur lequel la deuxième plaque de masse conductrice (5) est disposée ;

une pluralité de premières lignes ruban (13, 23) disposées sur, parmi les deux plans du deuxième substrat diélectrique (7), un plan opposé au plan sur lequel la deuxième plaque de masse conductrice (5) est disposée aux positions faisant face aux antennes à plaque (3-1 à 3-9) individuellement ;

une pluralité de secondes lignes ruban (15, 24) disposées à l'intérieur du troisième substrat diélectrique à des positions faisant face aux antennes à plaque (3-1 à 3-9) individuellement ; et

une pluralité de fentes (17) formées à l'intérieur de la deuxième plaque de masse conductrice (5) à des positions faisant face aux antennes à plaque (3-1 à 3-9) individuellement,

dans lequel chacune des fentes (17) est configurée pour exciter l'une des antennes à plaque (3-1 à 3-9) situées à une position opposée lorsque l'alimentation est fournie par l'une des premières lignes ruban (13, 23) et l'une des secondes lignes ruban (15, 24).

10. Dispositif d'antenne réseau selon la revendication 9, comprenant en outre :

un quatrième substrat diélectrique disposé sur, parmi les deux plans de la troisième plaque de masse conductrice, un plan opposé au plan sur lequel le troisième substrat diélectrique est disposé ; et

une pluralité de circuits d'ajustement (32) pour ajuster une phase et une amplitude d'un signal émis ou reçu par l'une des antennes à plaque (3-1 à 3-9), la pluralité de circuits d'ajustement (32) disposés sur, parmi les deux plans du quatrième substrat diélectrique, un plan opposé au plan sur lequel la troisième plaque de masse conductrice est disposée, chacun des circuits d'ajustement (32) étant connecté électriquement à chacune des premières et secondes lignes ruban disposées à des positions opposées à l'une des antennes à plaque (3-1 à 3-9).

11. Dispositif d'antenne réseau selon la revendication 2,

dans lequel chacune des antennes à plaque (3-1 à 3-9) prévues dans la première plaque de masse conductrice (2) est une première antenne à plaque, et

une pluralité de secondes antennes à plaque (3-1 à 3-9) sont prévues sur l'un, parmi les deux plans du deuxième substrat diélectrique (7), un plan auquel la pluralité d'éléments conducteurs (4) est connectée.

12. Dispositif d'antenne réseau selon la revendication 11,

dans lequel la couche d'air (6) est une première couche d'air, les entretoises sont de premières entretoises, et le dispositif d'antenne réseau comprend en outre de secondes entretoises pour former une seconde couche d'air (9) entre la deuxième plaque de masse conductrice (5) et le deuxième substrat diélectrique (7).

13. Dispositif d'antenne réseau selon la revendication 2, dans lequel les premières lignes ruban (13, 23) et les secondes lignes ruban (15, 24) sont câblées sur un même plan à l'intérieur du deuxième substrat diélectrique (7), et chacune des premières lignes ruban (13, 23) et des secondes lignes ruban (15, 24) est configurée pour exciter les antennes à plaque (3-1 à 3-9).

# FIG. 1

# FIG. 2

## FIG. 3

## FIG. 4

## FIG. 5

# FIG. 6

# FIG. 7

# FIG. 8

## FIG. 9

## FIG. 10

## FIG. 11

## FIG. 12

## FIG. 13

# FIG. 14

# FIG. 15

# FIG. 16

## FIG. 17

## FIG. 18

## FIG. 19

FIG. 20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009188895 A
- US 2012154238 A1
- US 2016049723 A1